# EUROPEAN PATENT APPLICATION

(11) **EP 1 531 187 A2**
(43) Date of publication of application: **18.05.2005**
(21) Application number: 04445031.0
(22) Date of filing: 15.03.2004
(51) Int. Cl.: C22C 29/02, C23C 30/00

(54) **Coated cutting tool insert for machining of cast irons**

(30) Priority: 24.03.2003 SE 0300781
(71) Applicant: SECO TOOLS AB, S-737 82 Fagersta (SE)
(72) Inventor: Larsson, Andreas, 737 47 Fagersta (SE); Zackrisson, Jenni, 737 47 Fagersta (SE)
(74) Representative: Taquist, Lennart

(57) **Abstract**

The present invention concerns a coated cemented carbide cutting tool insert particularly useful for turning of cast irons. The cutting tool insert is characterised by a cemented carbide body comprising WC, cubic carbonitrides, a W-alloyed Co binder phase, a surface zone of the cemented carbide body that is binder phase enriched and nearly free of cubic carbonitride phase, and a coating including an innermost layer of TiCₓN_{y}O_{z} with equiaxed grains, a layer of TiCₓN_{y}O_{z} with columnar grains and at least one layer of Al₂O₃.

## Description

The present invention concerns a coated cemented carbide cutting tool insert particularly useful for turning of cast irons. The insert has a body with a tough Co binder phase, WC and cubic carbonitrides as hard phases, and a wear resistant coating. The surface zone of the insert body is of a different elemental composition than the bulk composition, yielding simultaneously good wear resistance, plastic deformation resistance and edge toughness.

Coated cemented carbide inserts with binder phase enriched surface zones are used for machining of steel and stainless steel materials. The binder phase enriched surface zone widens the application area towards tougher cutting operations. In inserts for turning of cast irons these cemented carbide grades have usually not showed good performance. Cemented carbide grades dedicated for machining of cast irons have traditionally been designed with low Co content, small WC grain size, and no or very small additions of cubic carbides, for the reason of WC grain growth inhibition only. Such cutting tool materials have relatively high room temperature hardness, fair crack propagation resistance and bulk toughness properties. However, in difficult applications demanding a high amount of toughness due to noncontinuous cuts or more difficult to machine cast irons, the traditional grades are too brittle, resulting in edge chipping or insert breakage, one consequence being a lower productivity due to the need to use more moderate cutting data.

The cemented carbides in the traditional grades for machining cast irons sometimes have limited plastic deformation resistance, and in some operations also limited wear resistance. To improve these properties, a decrease of the WC grain size and lowering of the Co binder phase content and/or an increased addition of cubic carbonitride forming elements is needed. Each of these changes will decrease the insert toughness.

Methods to improve the toughness behaviour by introducing an essentially cubic carbide free and binder phase enriched surface zone are known. US 4,277,283, US 4,610,931 and US 4,548,786 describe methods to accomplish binder phase enrichment in the surface region by dissolution of cubic carbide phase close to the insert surfaces. The methods require that the cubic carbide phase contains some nitrogen, since dissolution of cubic carbide phase at the sintering temperature requires a partial pressure of nitrogen, nitrogen activity, within the body being sintered exceeding the partial pressure of nitrogen within the sintering atmosphere. The nitrogen can be added through the furnace atmosphere during the sintering cycle and/or directly through the powder. The dissolution of cubic carbide phase, preferentially in the surface region, results in small volumes that will be filled with binder phase giving the desired binder phase enrichment. As a result, a surface zone consisting of essentially WC and binder phase is obtained.

EP-A-1 026 271 relates to a coated cemented carbide insert for turning of steels. The insert has a highly alloyed Co-binder phase, 4-12, preferably 7-10, percent by weight of cubic carbides and a WC grain size of 1-4, preferably 2-3 µm. The binder phase enriched surface zone is of a thickness <20 µm and along a line in the direction from the edge to the centre of the insert the binder phase content increases essentially monotonously until it reaches the bulk composition. The coating of the insert comprises 3-12 µm of columnar TiCN and 2-12 µm of Al₂O₃.

US 5,945,207 describes a cutting tool insert particularly useful for cutting of cast iron materials. The insert is characterised by a WC-Co cemented carbide body with 5-10 wt.% Co and <0.5% cubic carbides from groups IVb, Vb or VIb of the periodic table. The binder phase is highly W-alloyed and the surface composition is well defined. The coating comprises a layer of TiCₓN_{y}O_{z} with columnar grains, a layer of fine-grained textured α-Al₂O₃ and a top layer of TiCₓN_{y}O_{z} that has been removed along the edge line.

Surprisingly, it has now been found that improved performance when machining cast iron under difficult conditions can be obtained by a combination of many different features of the cutting tool insert. More specifically, it has been found that improvements with respect to edge strength, plastic deformation and wear resistance can simultaneously be obtained if the tool is manufactured such that a binder phase enriched, nearly cubic carbonitride free, surface zone is combined with a low Co binder content, a well defined WC grain size, and an addition of cubic carbonitride forming elements.

In combination with a hard wear resistant coating, said cutting tool insert shows excellent performance for turning cast irons in difficult operations. The unique properties of the tool allow a higher productivity to be maintained for a wider application area.

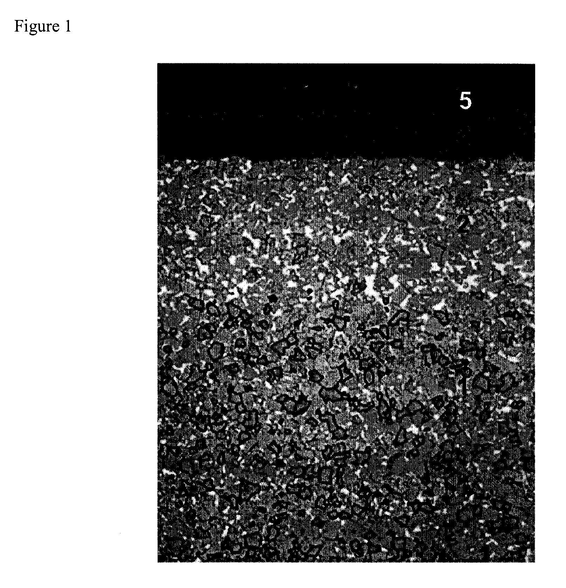

Fig 1 shows in 1000X the structure of the cutting tool insert according to the invention in which
1. Cemented carbide bulk
2. Cemented carbide surface zone
3. An innermost TiCₓN_{y}O_{z} layer
4. A second TiCₓN_{y}O_{z} layer
5. An Al₂O₃ layer

According to the present invention, a coated cutting tool is provided with a cemented carbide body having a composition of 3.0-9.0 wt.%, preferably 4.0-7.0 wt.% Co, 4.0-10.0 wt.%, preferably 6.0-9.0 wt.% of cubic carbonitride forming elements from groups IVb and Vb of the periodic table, N, C and WC. N is present in the sintered body in an amount corresponding to >1.0 %, preferably 1.7-5.0 %, of the weight of the elements from groups IVb and Vb.

The cemented carbide has a 5-50 µm, preferably 10-40 µm, thick surface zone, which is binder phase enriched and nearly free of cubic carbonitride phase. The maximum binder phase content of the surface zone is 1.2-3 by volume of the bulk binder phase content.

The cobalt binder phase is medium to highly alloyed with tungsten. The content of tungsten in the binder phase may be expressed as the S-value = σ / 16.1, where σ is the measured magnetic moment of the binder phase in µTm³kg⁻¹. The S-value depends on the tungsten content of the binder phase and increases with a decreasing tungsten content. Thus, for pure cobalt, or a binder that is saturated with carbon, S=1, and for a binder phase with a tungsten content corresponding to the borderline to η-phase formation, S=0.78.

It has now been found according to the present invention that improved cutting performance is achieved if the cemented carbide body has an S-value within the range 0.78-0.95, preferably 0.80-0.92.

Furthermore the mean intercept length of the tungsten carbide phase measured on a ground and polished representative cross section is in the range 0.50-0.95 µm, preferably 0.60-0.85. The mean intercept length of the cubic carbonitride phase is essentially the same as for tungsten carbide. The intercept length is measured by means of image analysis on micrographs with a magnification of 10000X and calculated as the average mean value of approximately 1000 intercept lengths.

In a preferred embodiment the amount of cubic carbonitrides corresponds to >4.0-10.0% by weight of the cubic carbonitride forming elements titanium, tantalum and niobium, preferably 6.0-9.0% by weight. The ratio between tantalum and niobium is within 0.8-4.5 by weight, preferably 1.2-3.0 by weight. The ratio between titanium and niobium is within 0.5-7.0 by weight, preferably 1.0-4.0 by weight.

The cutting tool insert according to the invention has a coating comprising:
- a first, innermost layer of TiCₓN_{y}O_{z} with 0.7≤x+y+z≤1, preferably z<0.5, more preferably y>x and z<0.2, most preferably y>0.7, with equiaxed grains and a total thickness <2 µm preferably >0.1 µm.
- a layer of TiCₓN_{y}O_{z} with 0.7≤x+y+z≤1, preferably with z<0.2, x>0.3 and y>0.2, most preferably x>0.4, with a thickness of 3-14 µm, preferably 4-12 µm, most preferably 5-10 µm, with columnar grains.
- at least one layer of Al₂O₃, preferably α-Al₂O₃, with a thickness of 2-14 µm, preferably 3-10 µm.
- the outer layer of Al₂O₃ can be followed by further layers of TiCₓN_{y}O_{z}, HfCₓN_{y}O_{z} or ZrCₓN_{y}O_{z} or mixtures thereof with 0.7≤x+y+z≤1.2, preferably with y>x and z<0.4, more preferably y>0.4, most preferably y>0.7, with thickness <3 µm, preferably 0.4-1.5 µm, but the Al₂O₃ layer can also be the outermost layer.

The present invention also relates to a method of making a coated cutting tool with a cemented carbide body composition of 3.0-9.0 wt.%, preferably 4.0-7.0 wt.% Co, >4.0-10.0 wt.%, preferably 6.0-9.0 wt.% of cubic carbonitride forming elements from groups IVb and Vb of the periodic table, N, C and WC. N is present in the sintered body in an amount corresponding to >1.0 %, preferably 1.7-5.0 %, of the weight of the metals from groups IVb and Vb.

Production of the cemented carbide body according to the invention is done in either of two ways or a combination thereof: (i) by sintering a presintered or compacted body containing a nitride or a carbonitride in an inert atmosphere or in vacuum as disclosed in US 4,610,931; or (ii) by nitriding the compacted body as disclosed in US 4,548,786 followed by sintering in an inert atmosphere or in vacuum.

The desired mean intercept length depends on the grain size of the starting powders and milling and sintering conditions and has to be determined by experiments. The desired S-value depends on the starting powders and sintering conditions and also has to be determined by experiments.

The layer of TiCₓN_{y}O_{z} with 0.7≤x+y+z≤1, preferably with z<0.2, x>0.3 and y>0.2, most preferably x>0.4, having a morphology of columnar grains, is deposited with MTCVD-technique onto the cemented carbide using acetonitrile as the carbon and nitrogen source for forming the layer in the temperature range of 700-950 °C.

The innermost TiCₓN_{y}O_{z} layer, the Al₂O₃ layers and subsequent TiCₓN_{y}O_{z}, HfCₓN_{y}O_{z} or ZrCₓN_{y}O_{z} layers are deposited according to known techniques.

The invention also relates to the use of cutting tool inserts according to the above for turning in cast irons at cutting speeds of 100-700 m/min, preferably 100-600 m/min, with feed values of 0.04-1.0 mm/rev., depending on cutting speed and insert geometry.

### Example 1

Grade A: A cemented carbide substrate in accordance with the invention with the composition 5.3 wt% Co, 3.3 wt% Ta, 2.1 wt% Nb, 2.0 wt% Ti, 6.0 wt% C, 0.2 wt% N and balance W, with a binder phase alloyed with W corresponding to an S-value of 0.89 was produced by conventional milling of powders, pressing of green compacts and subsequent sintering at 1430 °C. Investigation of the microstructure after sintering showed that the mean intercept length of the tungsten carbide phase was 0.71 µm and that the surface zone of the inserts consisted of a 25 µm thick binder phase enriched part nearly free of cubic carbonitride phase. The substrate was coated in accordance with the invention with subsequent layers deposited during the same coating cycle. The first layer was a 0.2 µm thick TiCₓN_{y}O_{z} layer with z<0.1 and y>0.6, having equiaxed grains. The second layer was 6.9 µm of columnar TiCₓN_{y}O_{z} deposited at 835-850°C with acetonitrile as carbon and nitrogen source, yielding an approximated carbon to nitrogen ratio x/y=1.5 with z<0.1. A 4.5 µm thick layer of Al₂O₃, consisting of the α-phase, was deposited at approximately 1000 °C. An outer layer of equiaxed nitrogen rich TiCₓN_{y}O_{z} with z<0.1 and y>0.8 was deposited to a thickness of 0.4 µm.

Grade B: A cemented carbide substrate with the composition 5.6 wt% Co, 1.0 wt% Ta, 0.6 wt% Nb, 1.9 wt% Ti, 6.01 wt% C, 0.13 wt% N, balance W, with a binder phase alloyed with W corresponding to an S-value of 0.89 was produced in the same way as Grade A. The mean intercept length of the tungsten carbide phase after sintering was 0.56 µm and the surface zone of the inserts consisted of a 20 µm thick binder phase enriched part nearly free of cubic carbonitride phase. The substrate was coated according to Grade A (according to the invention).

Grade C: A conventional cemented carbide substrate designed for cast iron machining, with the composition 6.0 wt% Co, 0.16 wt% Ta, 5.80 wt% C and balance W, a binder phase alloyed with W corresponding to an S-value of 0.94, and a mean intercept length of WC in the sintered body of 0.61 µm was combined with a coating according to Grade A (according to the invention).

Grade D: A substrate with average composition 5.5 wt% Co, 1.5 wt% Ta, 1.3 wt% Nb, 5.86 wt% C and balance W, having no cubic carbonitride free surface zone, a binder phase alloyed with W corresponding to an S-value of 0.89, and a mean intercept length of WC in the sintered body of 0.57 µm was combined with a coating according to Grade A (according to the invention).

Grade E: A commercial cemented carbide grade for cast iron machining in which a substrate according to Grade C is combined with a coating consisting of: a first thin layer of TiCₓN_{y}O_{z}; a second layer of columnar TiCₓN_{y}O_{z} with thickness 6.2 µm; a 2.1 µm thick layer of κ-Al₂O₃; and an outermost 1.2 µm thick N-rich TiCₓN_{y}O_{z} layer.

Grade A, Grade B, Grade C, Grade D and Grade E were tested with respect to edge toughness in the case of interrupted cuts. The machining operation was longitudinal turning of a cylindrical slotted bar.
- Material:: Steel SS1672
- Insert type:: CNMG120412-M5
- Cutting speed:: 140 m/min
- Feed:: 0.1, 0.125, 0.16, 0.20, 0.25, 0.315, 0.4, 0.5, 0.63, 0.8 mm/rev gradually increased after 10 mm length of cut
- Depth of cut:: 2.5 mm

Tool life criteria: Edge chipping or inserts breakage.

| Results | Mean feed at breakage (mm/rev.) |
|---|---|
| Grade A (Grade according to the invention) | 0.32 |
| Grade B (Coating according to the invention) | 0.20 |
| Grade C (Coating according to the invention) | 0.20 |
| Grade D (Coating according to the invention) | 0.15 |
| Grade E (Prior art) | 0.18 |

This test shows that combinations of the substrate and coating according to the invention exhibit equal or superior edge toughness as compared to conventional cast iron machining grades. The test also shows the detrimental effects that cubic carbonitride phase additions have on edge toughness if a gradient surface zone is not formed.

### Example 2:

Inserts according to Grade A, Grade B, and Grade C were tested in facing of a pre-drilled pearlitic nodular cast iron component. The tool life criterion was chipping of the cutting edges or insert breakage.

| | |
|---|---|
| Material: | Nodular cast iron, SS0737 |
| Component: | Axially drilled cylinder |
| Insert type: | CNMG120408-MR7 |
| Cutting speed: | 200 m/min |
| Feed: | 0.35 mm/rev. |
| Depth of cut: | 1.5 mm |
| Cutting conditions: | Heavy interrupted cut |
| Coolant: | Yes |

| | |
|---|---|
| Results: | Number of passes |
| Grade A (Grade according to the invention) | 8 (minor chipping) |
| Grade B (Grade according to the invention) | 4 (severe chipping) |
| Grade C (Coating according to the invention) | 4 (insert breakage) |

### Example 3:

Inserts according to Grade A, Grade C, and Grade D were tested in longitudinal turning of a nodular cast iron. The plastic deformation resistance of the different grades was investigated and compared.

| | |
|---|---|
| Material: | Nodular cast iron, SS0727 |
| Insert type: | CNMG120412-M5 |
| Cutting speed: | 350 m/min |
| Feed: | 0.4 mm/rev. |
| Depth of cut: | 2.5 mm |
| Coolant: | No |
| Time in cut: | 5 min |

| | |
|---|---|
| Results: | Edge depression |
| Grade A (Grade according to the invention) | 20 µm |
| Grade B (Coating according to the invention) | 20 µm |
| Grade C (Coating according to the invention) | 30 µm |

As is shown in this test, the plastic deformation resistance of Grade A is not impaired by the presence of the Co enriched cubic carbonitride free surface zone.

### Example 4:

Inserts according to Grade A, Grade B, Grade C, and Grade E were tested in facing of a housing. The inserts were inspected after production of 20 components and the number of micro-chippings occurring along the cutting edge was counted.

| | |
|---|---|
| Material: | Nodular cast iron, SS0732 |
| Insert type: | CNMG120412-M5 |
| Cutting speed: | 250 m/min |
| Feed: | 0.35 mm/rev. |
| Depth of cut: | 2 mm |
| Coolant: | No |
| Number of components: | 20 |

| | |
|---|---|
| Results: | Number of micro chippings |
| Grade A (Grade according to the invention) | 2 |
| Grade C (Coating according to the invention) | 6 |
| Grade E (Prior art) | 8 |

This test shows the improved edge toughness reached with Grade A, the grade according to the invention.

## Claims

1. A cutting tool insert, comprising a cemented carbide body and a coating particularly useful for turning of cast irons **characterized in** said body having a composition of 3.0-9.0 wt.%, preferably 4.0-7.0 wt.% Co, >4.0-10.0 wt.%, preferably 6.0-9.0 wt.% of cubic carbonitride forming elements from groups IVb and Vb of the periodic table, N, C, and WC, and a 5-50 µm, preferably 10-40 µm, thick surface zone, which is binder phase enriched and nearly free of cubic carbonitride phase, with a maximum binder phase content in the surface zone of 1.2-3 by volume of the bulk binder phase content and **in that** said coating comprises
- a first, innermost layer of TiCₓN_{y}O_{z} with 0.7≤x+y+z≤1, preferably z<0.5, more preferably y>x and z<0.2, most preferably y>0.7, with equiaxed grains and a total thickness <2 µm preferably >0.1 µm
- a layer of TiCₓN_{y}O_{z} with 0.7≤x+y+z≤1, preferably with z<0.2, x>0.3 and y>0.2, most preferably x>0.4, with a thickness of 3-14 µm, preferably 4-12 µm, most preferably 5-10 µm, with columnar grains
- at least one layer of Al₂O₃ with a thickness of 2-14 µm, preferably 3-10 µm, most preferably 3-8 µm.

2. A cutting tool insert according to the preceding claim **characterized in** furthermore comprising an outer layer of TiCₓN_{y}O_{z}, HfCₓN_{y}O_{z} or ZrCₓN_{y}O_{z} or mixtures thereof with 0.7≤x+y+z≤1.2, preferably with y>x and z<0.4, more preferably y>0.4, most preferably y>0.7, with thickness <3 µm, preferably 0.4-1.5 µm.

3. A coated cutting tool insert according to any of the preceding claims **characterised in that** the S-value of the cemented carbide body is within the range 0.78-0.95, preferably 0.80-0.92 and that the mean intercept length of the WC phase is 0.50-0.95 µm, preferably 0.60-0.85 µm.

4. A coated cutting tool insert according to any of the preceding claims **characterised in that** N is present in the sintered body in an amount corresponding to >1.0 %, preferably 1.7-5.0 %, of the weight of the elements from groups IVb and Vb of the periodic table.

5. A coated cutting tool insert according to any of the preceding claims **characterised in that** the amount of cubic carbonitrides corresponds to 0.5-4.0% by weight of the cubic carbonitride forming elements titanium, tantalum and niobium, preferably 1.0-4.0% by weight.

6. A coated cutting tool insert according to any of the preceding claims **characterised in that** the ratio between tantalum and niobium is within 0.8-4.5 by weight, preferably 1.2-3.0 by weight, and the ratio between titanium and niobium is within 0.5-7.0 by weight, preferably 1.0-4.0 by weight.

7. A method of making a cutting tool insert, comprising a cemented carbide body and a coating particularly useful for turning of cast irons and low alloyed steels **characterized in** said body having a composition of 3.0-9.0 wt.%, preferably 4.0-7.0 wt.% Co, 4.0-10.0 wt.%, preferably 6.0-9.0 wt.% of cubic carbonitride forming elements from groups IVb and Vb of the periodic table, N, C, and WC, and a 5-50 µm, preferably 10-40 µm, thick surface zone, which is binder phase enriched and nearly free of cubic carbonitride phase, with a maximum binder phase content in the surface zone of 1.2-3 by volume of the bulk binder phase content and **in that** said coating comprises
- a first, innermost layer of TiCₓN_{y}O_{z} with 0.7≤x+y+z≤1, preferably z<0.5, more preferably y>x and z<0.2, most preferably y>0.7, with equiaxed grains and a total thickness <2 µm preferably >0.1 µm
- a layer of TiCₓN_{y}O_{z} with 0.7≤x+y+z≤1, preferably with z<0.2, x>0.3 and y>0.2, most preferably x>0.4, with a thickness of 3-14 µm, preferably 4-12 µm, most preferably 5-10 µm, with columnar grains
- at least one layer of Al₂O₃ with a thickness of 2-14 µm, preferably 3-10 µm, most preferably 3-8 µm.

8. A method of making a cutting tool insert according to claim 7 **characterized in** furthermore comprising an outer layer of TiCₓN_{y}O_{z}, HfCₓN_{y}O_{z} or ZrCₓN_{y}O_{z} or mixtures thereof with 0.7≤x+y+z≤1.2, preferably with y>x and z<0.4, more preferably y>0.4, most preferably y>0.7, with thickness <3 µm, preferably 0.4-1.5 µm.

9. Use of a cutting tool insert according to any of the claims 1-6 for turning in cast irons at cutting speeds of 100-700 m/min, preferably 100-600 m/min, with feed values of 0.04-1.0 mm/rev., depending on cutting speed and insert geometry.
